(19) Europäisches Patentamt / European Patent Office / Office européen des brevets

(11) **EP 4 734 375 A1**

(12) **EUROPEAN PATENT APPLICATION**

(43) Date of publication:
**29.04.2026 Bulletin 2026/18**

(21) Application number: **24306772.5**

(22) Date of filing: **22.10.2024**

(51) International Patent Classification (IPC):
**H03M 1/08** *(2006.01)*    **H03M 1/74** *(2006.01)*
**H03K 17/16** *(2006.01)*    **H03M 3/02** *(2006.01)*
**H03M 3/04** *(2006.01)*

(52) Cooperative Patent Classification (CPC):
**H03M 3/464; H03K 17/165; H03M 1/0863;**
**H03M 3/346;** H03M 1/742

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **Scalinx**
**75013 Paris (FR)**

(72) Inventors:
• **GUIRAUD, Lionel**
  **14750 St Aubin Sur Mer (FR)**
• **ROLINDEZ, Luis**
  **14000 Caen (FR)**

(74) Representative: **Murgitroyd & Company**
**165-169 Scotland Street**
**Glasgow G5 8PL (GB)**

(54) **A SWITCHING VOLTAGE-CONTROLLED CURRENT SOURCE**

(57)    A switching voltage-controlled current source comprising: a current source input terminal for receiving a first input logic signal and a current source output terminal for outputting current; a first logic circuit comprising a first logic input terminal connected to the current source input terminal, a first logic output terminal for outputting a current control signal, a first supply terminal for connecting to a power supply and a first ground terminal for connecting to the ground; a first resistor coupled between the first logic output terminal and the current source output terminal; a second resistor coupled between the power supply and first supply terminal and a third resistor coupled between the ground and the first ground terminal; wherein the first logic circuit is operable to selectively couple the second resistor or the third resistor to the first resistor; a first charge supply circuit and a second charge supply circuit.

**FIG. 5**

**Description**

**Field of the invention**

This invention relates to a switching voltage controlled current source, a digital-to-analogue converter comprising one or more such switching voltage controlled current sources, and a Delta-Sigma modulator comprising one or more such digital-to-analogue converters.

**Background to the invention**

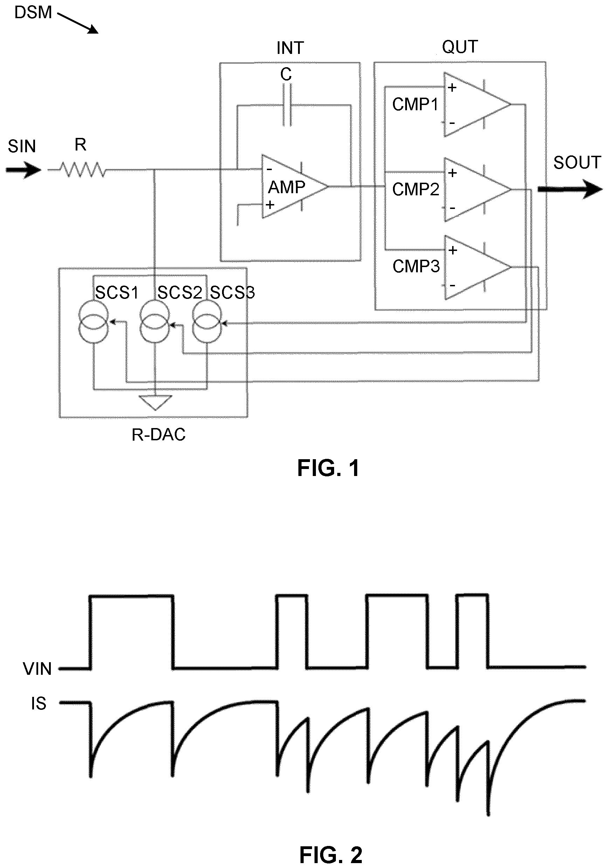

A conventional Delta-Sigma modulator (DSM) comprises an integrator which may function as an analogue loop filter (e.g., a low-pass filter or a bandpass filter), a quantizer and a return digital-to-analogue converter (DAC). Figure 1 schematically depicts an example multi-bit DSM. The DSM comprises an integrator INT comprising an operational amplifier AMP and a capacitor C. The DSM further comprises a quantizer QUT comprising three comparators CMP1-CMP3 each of which is configured to output a logic signal. The DSM further comprises a return DAC R-DAC comprising three unit current sources CS1-CS3 which are respectively controlled by the three logic signals outputted by the quantizer QUT. The input signal SIN is coupled to the integrator INT through a resistor R and a modulated signal SOUT is outputted from the quantizer QUT.

One of the key performance indicators of a DSM is the linearity which indicates the DSM's capability of avoiding generation of harmonics related to the input signal. The return DAC is often the main contributor to the generation of any undesired harmonics. With reference to Figure 1, each unit current source CS1, CS2, CS3 of the return DAC R-DAC is operable to deliver a bipolar output current the polarity of which is determined by the logic signal outputted by one of the comparators CMP1, CMP2, CMP3 of the quantizer QUT. Undesired harmonics may be generated due to several factors such as for example a mismatch between the output current values of different unit current sources CS1-CS3; or it may be generated by a so-called "memory effect" which results from the voltage of one or more nodes settling to different values depending on the switching speed (i.e. how fast the logic state changes) of the logic signal.

Parasitic capacitance at those nodes receiving a high-speed logic signal is the main cause of such "memory effect". Figure 2 shows an input logic signal VIN for controlling a unit current source of the return DAC R-DAC and an internal signal IS (a transitional voltage at a certain node) of the current source contributing to the output current. The parasitic capacitance significantly lengthens the time required for the voltage at a certain voltage node to completely settle, which results in the voltage settling time being longer than the time a particular logic state (e.g., logic 0 or logic 1) lasts (or the duration of a certain signal pulse). Consequently, the output current OC of the unit current source deviates from the 'ideal' output current OC free from the impact of the memory effect and such deviation is input data dependent (also known as input data dependent behavior).

It is the object of the present disclosure to alleviate at least these problems with the prior art.

**Summary of the invention**

Aspects of the present disclosure are set out in the accompanying independent and dependent claims. Combinations of features from the dependent claims may be combined with features of the independent claims as appropriate and not merely as explicitly set out in the claims.

According to a first aspect of the present invention, there is provided a switching voltage-controlled current source, comprising: a current source input terminal for receiving a first input logic signal and a current source output terminal for outputting current; a first logic circuit comprising a first logic input terminal connected to the current source input terminal, a first logic output terminal for outputting a current control signal, a first supply terminal for connecting to a power supply and a first ground terminal for connecting to the ground; a first resistor coupled between the first logic output terminal and the current source output terminal; a second resistor coupled between the power supply and first supply terminal and a third resistor coupled between the ground and the first ground terminal; wherein the first logic circuit is operable to selectively couple the second resistor or the third resistor to the first resistor; a first charge supply circuit configured to supply a first amount of electric charge to compensate a first charge difference in a parasitic capacitance formed at a current source internal node connected to the first logic output terminal and one end of the first resistor in response to switching of the first input logic signal from a first logic state to a second logic state; and a second charge supply circuit configured to supply a second amount of electric charge to compensate a second charge difference in the parasitic capacitance formed at the current source internal node in response to switching of the first input logic signal from the second logic state to the first logic state.

By supplying a suitable amount of electric charge to compensate a difference in the amount of electric charge in a parasitic capacitance formed at an internal node, the proposed switching-voltage controlled current source is capable of significantly reducing or even completely cancelling a transitional current resulting from the change in the electric charge in the parasitic capacitance after every switching of the logic state of the input logic signal. This in turn ensures the resultant transitional voltage settles to its initial voltage value in a fast manner, thereby minimizing or preventing the negative impact of the memory effect.

In an embodiment, the first charge supply circuit may comprise: a first charge supply input terminal connected to the current source input terminal; a first charge supply output terminal connected to the first supply terminal of the first logic circuit; a first internal voltage node; a second logic circuit comprising a second logic input terminal connected to the first charge supply input terminal and a second logic output terminal, said second logic circuit being configured to have the same functional behavior as the first logic circuit; a first capacitor coupled between the second logic output terminal and the first internal voltage node; a first switch coupled between the first charge supply output terminal and the first internal voltage node, the state of the first switch being controlled by the first input logic signal; and a second switch coupled between the first internal voltage node and the power supply, and the state of the second switch being controlled by a second input logic signal having an opposite polarity to the first input logic signal.

In an embodiment, the second charge supply circuit may comprise: a second charge supply input terminal connected to the current source input terminal; a second charge supply output terminal connected to the first ground terminal of the first logic circuit; a second internal voltage node; a third logic circuit comprising a third logic input terminal connected to the second charge supply input terminal and a third logic output terminal, said third logic circuit being configured to have the same functional behavior as the first logic circuit; a second capacitor coupled between the second logic output terminal and the second internal voltage node; a third switch coupled between the second charge supply output terminal and the second internal voltage node, the state of the third switch being controlled by the first input logic signal; and a fourth switch coupled between the second internal voltage node and the ground, and the state of the fourth switch being controlled by the second input logic signal.

In an embodiment, the electric resistance of the second resistor and/or the third resistor may be adjustable. In an embodiment, the second resistor may comprise a first fixed resistor and one or more second fixed resistors, wherein each of the one or more second fixed resistors is in series with a fifth switch, and each pair of a second fixed resistor and a fifth switch is parallelly connected to the first fixed resistor. In an embodiment, the third resistor may comprise a third fixed resistor and one or more fourth fixed resistors, wherein each of the one or more fourth fixed resistors is in series with a sixth switch, and each pair of a fourth fixed resistor and a sixth switch is parallelly connected to the third fixed resistor.

In an embodiment, the first switch and the second switch of the first charge supply circuit may both be P-type MOSFET transistors, and/or the third switch and the fourth switch of the second charge supply circuit are both N-type MOSFET transistors.

In an embodiment, the first capacitor of the first charge supply circuit is coupled to the power supply and decoupled from the first charge supply output terminal when the first logic circuit decouples the first resistor from the second resistor. In an embodiment, the second capacitor of the second charge supply circuit is coupled to the ground and decoupled from the second charge supply output terminal when the first logic circuit decouples the first resistor from the third resistor.

In an embodiment, the first capacitor of the first charge supply circuit is decoupled from the power supply and coupled to the first charge supply output terminal when the first logic circuit couples the first resistor to the second resistor. In an embodiment, the second capacitor of the second charge supply circuit is decoupled from the ground and coupled to the second charge supply output terminal when the first logic circuit couples the first resistor to the third resistor.

In an embodiment, the switching voltage-controlled current source may be operable to output a first current when the first input logic signal is of a first state and output a second current when the first input logic signal is of a second state, said second current having a similar or same absolute value as the first current but with an opposite polarity.

In an embodiment, the second logic circuit of the first charge supply circuit and the third logic circuit of the second charge supply circuit may be same as the first logic circuit.

In an embodiment, the second logic circuit of the first charge supply circuit and the third logic circuit of the second charge supply circuit may be different than the first logic circuit but with a same functional behavior as the first logic circuit.

In an embodiment, the first logic circuit may be an inverter.

In an embodiment, the first logic state is a logic HIGH and the second logic state is a logic LOW.

In a second aspect of the present invention, there is provided a digital-to-analog converter comprising at least one switching voltage-controlled current source according to the first aspect.

In a third aspect of the present invention, there is provided a delta-sigma modulator comprising: at least one digital-to-analog converter of the second aspect, and at least one integrator for receiving the current from the at least one switching voltage-controlled current source of the at least one digital-to-analog converter of the second aspect.

In a fourth aspect of the present invention, there is provided a method of compensating a parasitic capacitance in a switching voltage-controlled current source. The switching voltage-controlled current source may comprise: a current source input terminal for receiving a first input logic signal and a current source output terminal for outputting current; a first logic circuit comprising a first logic input terminal connected to the current source input terminal, a first logic output terminal for outputting a current control signal, a first supply terminal for connecting to a power supply and a first ground terminal for connecting to the ground; a first resistor coupled between the first logic output terminal and the current source output terminal; a second resistor coupled between the power supply and the first supply terminal, and a third resistor coupled between the ground and the first ground terminal; wherein the first logic circuit is operable to selectively couple the second resistor or the third resistor to the first resistor. The method may comprise: in response to switching of the first input logic signal from a first logic state to a second logic state, generating a first amount of electric charge by a first charge supply circuit to compensate a first charge difference in a parasitic capacitance formed at a current source internal node connected to the first logic output terminal and one end of the first resistor; and in response to switching of the first input logic signal from the second logic state to the first logic state, generating a second amount of electric charge by a second charge supply circuit to compensate a second charge difference in the parasitic capacitance formed at the current source internal node.

It will be appreciated that any features described herein as being suitable for incorporation into one or more aspects or embodiments of the present disclosure are intended to be generalizable across any and all aspects and embodiments of the present disclosure. Other aspects of the present disclosure can be understood by those skilled in the art in light of the description, the claims, and the drawings of the present disclosure. The foregoing general description and the following detailed description are exemplary and explanatory only and are not restrictive of the claims.

**Brief Description of the Drawings**

Embodiments of the present disclosure will be described hereinafter, by way of example only, with reference to the accompanying drawings in which like reference signs relate to like elements and in which:

Figure 1 shows a schematic diagram of a prior art Delta-Sigma modulator;

Figure 2 schematically illustrates an input logic signal for controlling a current source for use in a Delta-Sigma modulator (e.g. as shown in Figure 1) and an internal signal (a transitional voltage at a certain node) of the current source contributing to the output current;

Figure 3 shows a schematic diagram of a prior art electronic circuit comprising a switching voltage-controlled current source connected to a single-ended integrator;

Figure 4 shows a schematic diagram of another prior art electronic circuit comprising an improved switching voltage-controlled current source connected to a single-ended integrator;

Figure 5 shows a schematic diagram of an electronic circuit comprising an embodiment of the proposed switching voltage-controlled current source connected to a single-ended integrator;

Figures 6A and 6B schematically illustrate a falling-edge operation of the proposed switching voltage-controlled current source when the input logic signal is switched from a logic HIGH to a logic LOW; and

Figures 7A and 7B schematically illustrate a rising-edge operation of the proposed switching voltage-controlled current source when the input logic signal is switched from a logic LOW to a logic HIGH.

**Detailed Description**

When used in a DSM (e.g., the DSM shown in Figure 1), a unit current source typically comprises a MOSFET (Metal-Oxide-Semiconductor Field-Effect Transistor) current source followed by a switch transistor pair configured to generate a differential output current depending on the state of the input logic signal. It is however advantageous to use a voltage-controlled unit current source comprising a resistor connected at one end to the input terminal of the integrator and at the other end to the output terminal of a logic circuit (e.g., inverter) because of its simpler configuration.

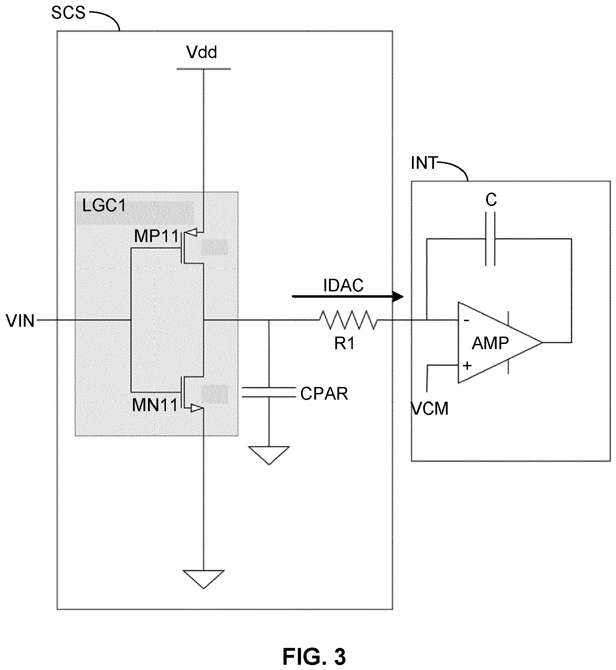

Figure 3 schematically depicts a switching voltage-controlled current source SCS connected to a single-ended integrator. As shown in Figure 3, the switching voltage-controlled current source SCS comprises a logic circuit LGC1 and a resistor R1 coupling the current source SCS to the integrator INT. The logic circuit LGC1 comprises a supply terminal for connecting to the power supply Vdd and a ground terminal for connecting to the ground. In this particular example, the logic circuit LGC1 is an inverter comprising a P-type MOSFET transistor MP11 and a N-type MOSFET transistor MN11, wherein the source terminal of the P-type MOSFET transistor MP11 is connected to the supply terminal (and thus to the power supply Vdd) and the source terminal of the N-type MOSFET transistor MN11 is connected to the ground terminal (and thus to the ground). The drain terminals of the P-type MOSFET transistor MP11 and the N-type MOSFET transistor MN11 are connected to one end of the resistor R1. The integrator INT has the same configuration as the one shown in Figure 1.

The input logic signal VIN controls the output current IDAC of the switching voltage-controlled current source SCS. If assuming that the on-state impedance of the N-type MOSFET transistor MN1 and the P-type MOSFET transistor MP1 is negligible in comparison to the resistor R1 and the voltage VCM at the positive input terminal of the operational power amplifier AMP is one half of the power supply voltage Vdd, the output current IDAC is equal to $\frac{Vdd-VCM}{R1} = Vdd/(2*R1)$ in the case of the input signal VIN being a logic LOW (i.e. *VIN = 0V*), and is equal to $-\frac{VCM}{R1} = -Vdd/(2*R1)$ in the case of the input signal VIN being a logic HIGH (i.e. *VIN = Vdd*).

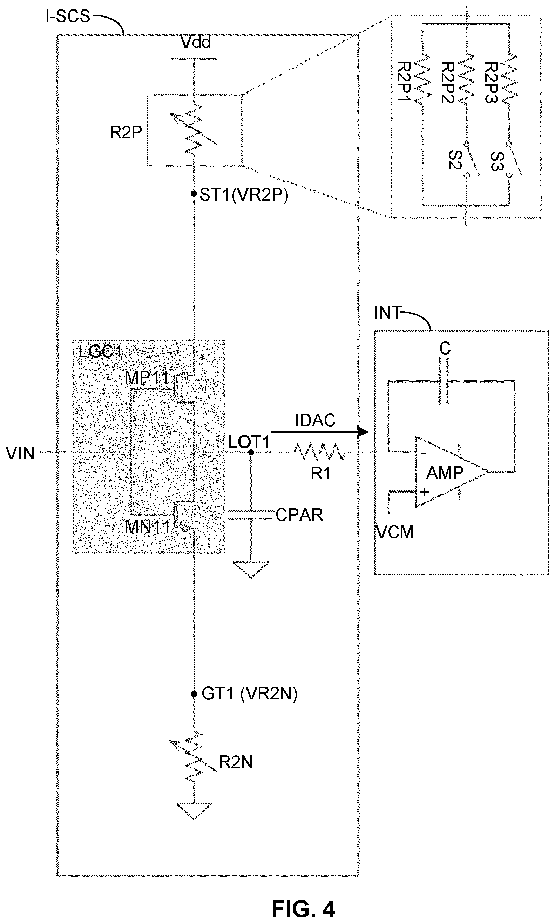

Therefore, for a multi-bit DSM (e.g., as shown in Figure 1) comprising several identical unit current sources (e.g., the current source SCS shown in Figure 3), it is desirable to adjust the output current which is defined by the resistor R1 (see above) of each unit current source so as to compensate for any mismatch in the resistance value of the resistor R1 between different unit current sources. An existing approach is adding two adjustable resistors R2P and R2N to each unit current source. As shown in Figure 4, a first adjustable resistor R2P is placed between the power supply Vdd and the supply terminal of the logic circuit LGC1 (also the source terminal of the P-type MOSFET transistor MP1) and a second adjustable resistor R2N is placed between the ground and the ground terminal of the logic circuit LGC1 (also the source terminal of the N-TYPE MOSFET transistor MN1). When the input signal VIN is a logic LOW (i.e. *VIN = 0V*), the first adjustable resistor R2P can be used to adjust the output current IDAC which is equal to $V_{dd}/(2 * (R1 + R2P))$. When the input signal VIN is a logic HIGH (i.e. *VIN = V_{dd}*), the second adjustable resistor R2N can be used to adjust the output current IDAC which is equal to $-V_{dd}/(2 * (R1 + R2N))$.

In this example implementation, the first adjustable resistor R2P comprises a first fixed resistor R2P1 which is parallelly connected to a second fixed resistor R2P2 and a third fixed resistor R2P3. The second fixed resistor R2P2 is serially connected to switch S2 and the third fixed resistor R2P3 is serially connected to switch S3. The second adjustable resistor R2N is configured a similar manner and thus is not shown in the figure for the sake of simplicity. The resistance of the first adjustable resistor R2P or the second adjustable resistor R2N is adjustable through controlling the ON/OFF state of each switch. The resistance value of the first adjustable resistor R2P and the second adjustable resistor R2N may be a fraction of the resistance value of the resistor R1. In other examples, the first adjustable resistor R2P and/or the second adjustable resistor R2N may have a different configuration. For example, one of both of the first adjustable resistor R2P and the second adjustable resistor R2N may comprise one or more variable resistors with variable resistance.

With reference to Figure 4, the switching voltage-controlled current source I-SCS exhibits a parasitic capacitance CPAR at the internal voltage node LOT1 common to the output terminal LOT1 of the logic circuit LGC1 (connected to the drain terminals of the P-type MOSFET transistor and N-type MOSFET transistor) and one end of the resistor R1. This parasitic capacitance CPAR is the sum of the parasitic capacitance of the resistor R1, the parasitic capacitance of the drain terminal of the P-type MOSFET transistor MP1, the parasitic capacitance of the drain terminal of the N-type MOSFET transistor MN1, and the parasitic capacitance of the physical interconnects at this node LOT1.

When the input logic signal VIN is switched from a logic HIGH to a logic LOW, the parasitic capacitance CPAR is charged from 0V to Vdd. When the input logic signal VIN is switched from a logic LOW to a logic HIGH, the parasitic capacitance CPAR is discharged from Vdd to 0V. The amount of electric charge transferred from/to the internal voltage node (at which the switching induced parasitic capacitance exists) create a transitional current through the first adjustable resistor R2P or the second adjustable resistor R2N and thus a transitional voltage variation at nodes VR2P or VR2N. The time constant determined by *R2P \* CPAR* or *R2N \* CPAR* can be large enough such that the transitional voltage at the node VR2P or VR2N would have not returned to its initial value before the next switching of the logic state of the input logic signal VIN occurs (e.g., in case of a high speed input logic signal VIN). As such, the transitional voltage variations at the nodes VR2P and VR2N may have an input data dependent behavior (similar to the behavior of the internal signal IS shown in Figure 2). This would generate unwanted harmonics related to the input signal (e.g., the input signal SIN in Figure 1), thereby negatively impacting the linearity performance of the DSM.

Therefore, it is desirable to further improve on existing switching voltage-controlled current sources (e.g., the switching voltage-controlled current source I-SCS shown in Figure 4). Further improvement may be achieved by configuring a switching voltage-controlled current source in such a manner that an amount of electric charge will be supplied to the internal voltage node (at which parasitic capacitance CPAR exists) upon switching of the logic state of the input logic signal VIN. The supplied electrical charge may effectively compensate a difference in the amount of electric charge in the parasitic capacitance CPAR at the internal voltage node LOT1 and thus reduce or prevent the transitional current from flowing through the first adjustable resistor R2P or the second adjustable resistor R2N. This ensures that the transitional voltage VR2P or VR2N at the node ST1 or GT1 settles quickly to its initial value after each switching of the logic state of the input logic signal VIN, thereby preventing the input data dependent behavior. When such charge-compensated current sources are used in a DSM, the linearity performance of the DSM will be improved.

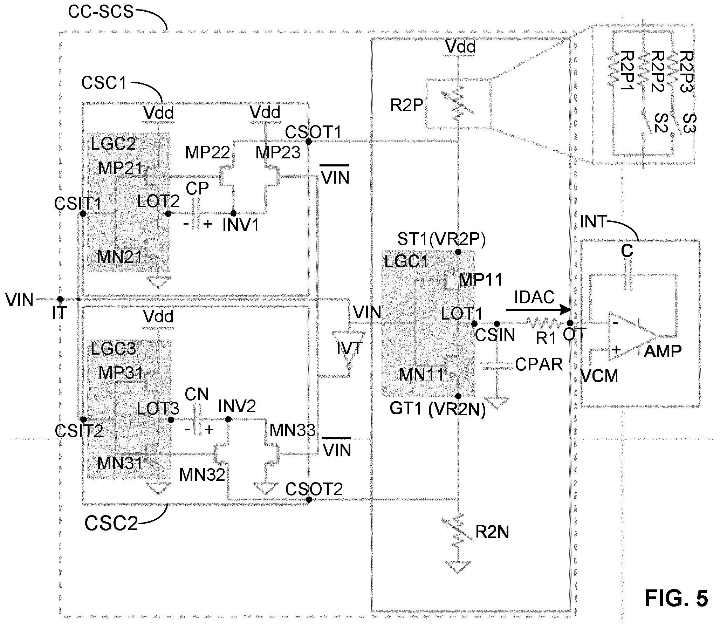

Accordingly, a first aspect of the present disclosure provides a switching voltage-controlled current source that is suitable for use in a DSM. Figure 5 schematically illustrates an electronic circuit comprising an embodiment of the proposed switching voltage-controlled current source CC-SCS coupled to a single-ended integrator INT via an internal resistor R1. The single-ended integrator INT is in the same configuration as the electronic circuit shown in Figure 3 or 4. It will be appreciated that the integrator INT may not be required or may be configured in a different configuration when the proposed switching voltage-controlled current source CC-SCS is used in a device other than a DSM. The main difference to the switching voltage-controlled current source I-SCS shown in Figure 4 may be that the proposed switching voltage-controlled current source CC-SCS comprises two additional charge supply circuits, i.e. the first charge supply circuit CSC1 and the second charge supply circuit CSC2. For the sake of simplicity, the working principle of the common part of the electronic circuit will not be described in detail again.

With reference to Figure 5, the switching voltage-controlled current source CC-SCS may comprise a current source input terminal IT for receiving a first input logic signal VIN and a current source output terminal OT for outputting current IDAC.

The switching voltage-controlled current source CC-SCS may further comprise a first logic circuit LGC1 which may comprise a first logic input terminal (not shown) connected to the current source input terminal IT, a first logic output terminal LOT1 for outputting a current control signal, a first supply terminal ST1 for connecting to a power supply Vdd, and a first ground terminal GT1 for connecting to the ground. In an embodiment, the first logic circuit LGC1 may be an inverter controlled by a single input logic signal VIN. The first logic circuit LGC1 may comprise a first P-type MOSFET transistor MP11 and a first N-type MOSFET transistor MN11, wherein the source terminal of the first P-type MOSFET transistor MP11 may be connected to the first supply terminal ST1 and the source terminal of the first N-TYPE MOSFET transistor MN11 may be connected to the first ground terminal GT1. The drain terminals of the first P-type MOSFET transistor MP11 and the first N-type MOSFET transistor MN11 may be connected to the first logic output terminal LOT1. In other embodiments, the first logic circuit LGC1 may comprise one or more logic circuits. For example, the first logic circuit LGC1 may comprise one or more AND gates, and/or one or more NAND gates, and/or one or more XOR gates, and/or one or more OR gate, and/or one or more NOR gates.

The switching voltage-controlled current source CC-SCS may further comprise a first resistor R1 coupled between the first logic output terminal LOT1 and the current source output terminal OT, a second resistor R2P coupled between the power supply Vdd and the first supply terminal ST1, and a third resistor R2N coupled between the ground and the first ground terminal GT1. The first logic circuit LGC1 may be operable to selectively couple the second resistor R2P or the third resistor R2N to the first resistor R1.

The switching voltage-controlled current source CC-SCS may further comprise a first charge supply circuit CSC1 configured to supply a first amount of electric charge to compensate a first charge difference in a parasitic capacitance CPAR formed at a current source internal node CSIN connected to the first logic output terminal LOT1 and one end of the first resistor R1 in response to switching of the first input logic signal VIN from a first logic state (e.g., a logic HIGH) to a second logic state (e.g., a logic LOW).

The switching voltage-controlled current source CC-SCS may further comprise a second charge supply circuit CSC2 configured to supply a second amount of electric charge to compensate a second charge difference in the parasitic capacitance CPAR formed at the current source internal node CSIN in response to switching of the first input logic signal VIN from the second logic state (e.g., a logic LOW) to the first logic state (e.g., a logic HIGH).

The first charge supply circuit CSC1 and the second charge supply circuit CSC2 may comprise a same or similar logic circuit. It is important that the first logic circuit LGC1 of the switching voltage-controlled current source CC-SCS, the second logic circuit LGC2 of the first charge supply circuit CSC1 and the third logic circuit LGC3 of the second charge supply circuit CSC2 are driven by the same input logic signal VIN (rather than one of the logic circuits being driven by one input logic signal while the others being driven by an inverted signal of the input logic signal). This may allow the three logic circuits LGC1, LGC2, LGC3 to operate in a substantially synchronous manner, thereby obtaining the desired behavior at the node ST1 and the node GT1.

In an embodiment, the first charge supply circuit CSC1 may comprise a first charge supply input terminal CSIT1 connected to the current source input terminal IT, a first charge supply output terminal CSOT1 connected to the first supply terminal ST1 of the first logic circuit LGC1, and a first internal voltage node INV1. The first charge supply circuit CSC1 may further comprise a second logic circuit LGC2 which may comprise a second logic input terminal (not shown) connected to the first charge supply input terminal CSIT1 and a second logic output terminal LOT2. The second logic circuit LGC2 may be configured to have the same functional behavior as the first logic circuit LGC1.

In an embodiment, the second logic circuit LGC2 may be an inverter controlled by a single input logic signal VIN. The second logic circuit LGC2 may comprise a second P-type MOSFET transistor MP21 and a second N-type MOSFET transistor MN21, wherein the source terminal of the second P-type MOSFET transistor MP21 may be connected to the power supply Vdd and the source terminal of the second N-type MOSFET transistor MN21 may be connected to the ground. The drain terminals of the second P-type MOSFET transistor MP21 and the second N-type MOSFET transistor MN21 may be connected to the second logic output terminal LOT2.

The first charge supply circuit CSC1 may further comprise a first capacitor CP which may be coupled between the second logic output terminal LOT2 and the first internal voltage node INV1, a first switch MP22 coupled between the first charge supply output terminal CSOT1 and the first internal voltage node INV1, the state of the first switch MP22 being controlled by the first input logic signal VIN. The first charge supply circuit CSC1 may further comprise a second switch MP23 coupled between the first internal voltage node INV1 and the power supply Vdd, the state of the second switch MP23 being controlled by a second input logic signal $\overline{VIN}$ having an opposite polarity to the first input logic signal VIN. The second input logic signal $\overline{VIN}$ may be an inverted signal of the first input logic signal VIN e.g., obtained by feeding the first input logic signal VIN into an inverter IVT. In an embodiment, the first switch MP22 and the second switch MP23 of the first charge supply circuit CSC1 may each comprise a P-type MOSFET transistor.

In an embodiment, the second charge supply circuit CSC2 may comprise a second charge supply input terminal CSIT2 connected to the current source input terminal IT, a second charge supply output terminal CSOT2 connected to the first ground terminal GT1 of the first logic circuit LGC1, and a second internal voltage node INV2. The second charge supply circuit CSC2 may further comprise a third logic circuit LGC3 which may comprise a third logic input terminal (not shown) connected to the second charge supply input terminal CSIT2 and a third logic output terminal LOT3. The third logic circuit LGC3 may be configured to have the same functional behavior as the first logic circuit LGC1.

In an embodiment, the third logic circuit LGC3 may be an inverter controlled by a single input logic signal VIN. The third logic circuit LGC3 may comprise a third P-type MOSFET transistor MP31 and a third N-type MOSFET transistor MN31, wherein the source terminal of the third P-type MOSFET transistor MP31 may be connected to the power supply Vdd and the source terminal of the third N-type MOSFET transistor MN31 may be connected to the ground. The drain terminals of the third P-type MOSFET transistor MP31 and the third N-type MOSFET transistor MN31 may be connected to the third logic output terminal LOT3.

The second charge supply circuit CSC2 may further comprise a second capacitor CN which may be coupled between the third logic output terminal LOT3 and the second internal voltage node INV2. The second charge supply circuit CSC2 may further comprise a third switch MN32 coupled between the second charge supply output terminal CSOT2 and the second internal voltage node INV2, the state of the third switch MN32 being controlled by the first input logic signal VIN. The second charge supply circuit CSC2 may further comprise a fourth switch MN33 coupled between the second internal voltage node INV2 and the ground, the state of the fourth switch MN33 being controlled by the second input logic signal $\overline{VIN}$ having an opposite polarity to the first input logic signal VIN. In an embodiment, the third switch MN32 and the fourth switch MN33 of the second charge supply circuit CSC2 may each comprise a N-type MOSFET transistor.

The switching voltage-controlled current source CC-SCS may be operable to output a first current when the first input logic signal VIN is a first logic state and output a second current when the first input logic signal VIN is a second state, said second current having a similar or same absolute value IDAC as the first current but with an opposite polarity (i.e. an opposite current flow direction). By way of example, the first current IDAC may flow towards the integrator INT when the first input logic signal VIN is a logic LOW (e.g., VIN = 0V) and the second current IDAC may flow towards the first logic circuit LGC1 when the first input signal VIN is a logic HIGH.

In an embodiment, the second logic circuit LGC2 of the first charge supply circuit CSC1 and the third logic circuit LGC3 of the second charge supply circuit CSC2 may be same as the first logic circuit LGC1. In a different embodiment, the second logic circuit LGC2 of the first charge supply circuit CSC1 and the third logic circuit LGC3 of the second charge supply circuit CSC2 may be different than the first logic circuit LGC1 but may have a same functional behavior as the first logic circuit LGC1.

Falling-edge transition (i.e. switching from logic HIGH to logic LOW)

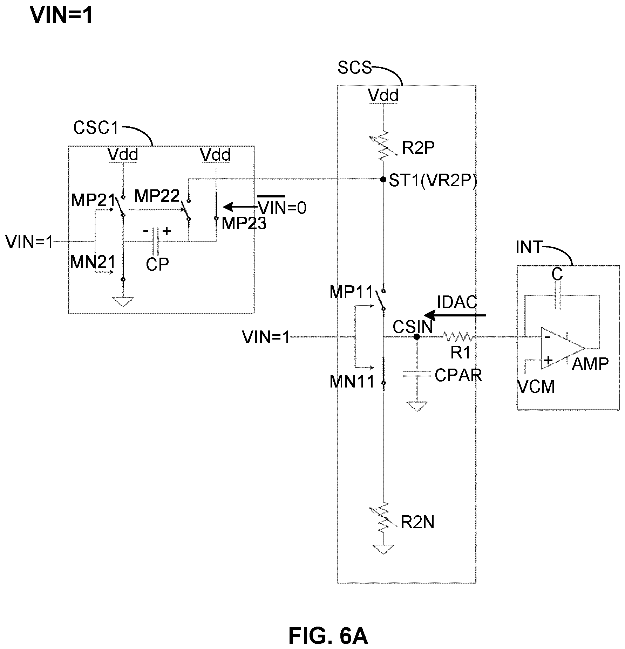

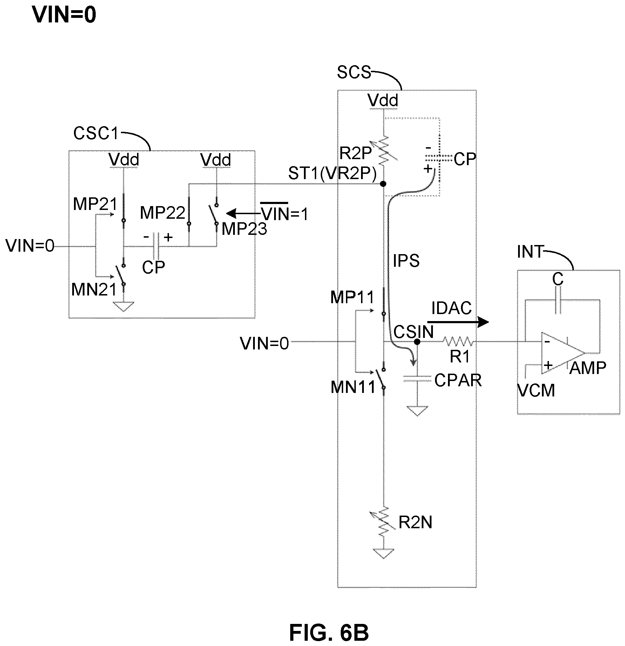

Figures 6A and 6B schematically illustrate a falling-edge operation of the switching voltage-controlled current source CC-SCS when the first input logic signal VIN is switched from a logic HIGH (e.g., VIN = 1V) to a logic LOW (e.g., VIN = 0V). At a falling edge transition, the first charge supply circuit CSC1 may be active.

With reference to Figure 6A, when the first input logic signal VIN is a logic HIGH (e.g., VIN = 1V), the first capacitor CP is coupled at one end to the power supply Vdd and at the other end to ground (via the second N-type MOSFET transistor MN21). The amount of electric charge stored by the first capacitor CP between its PLUS (+) and MINUS (-) terminals is substantially equal to *Vdd \* CP.* The voltage at the current source internal node CSIN (i.e. the voltage across the parasitic capacitance CPAR) is equal to *IDAC \* R2N* and the electric charge stored in the parasitic capacitance CPAR is substantially equal to (*IDAC \* R2N*) *\* CPAR.*

With reference to Figure 6B, when the first input logic signal VIN is switched from a logic HIGH (e.g., VIN = 1V) to a logic LOW (e.g., VIN = 0V), the first capacitor CP is coupled between the power supply Vdd (via the second P-type MOSFET transistor MP21) and the first supply terminal ST1 and the parasitic capacitance CPAR is coupled to the first supply terminal ST1 of the first logic circuit LGC1 (assuming the resistance of the first P-type MOSFET MP11 transistor is negligible). The voltage VR2P at the first supply terminal ST1 will settle to *Vdd - IDAC \* R2P.* The voltage across the first capacitor CP is substantially equal to *-IDAC \* R2P* and the voltage across the parasitic capacitance CPAR is substantially equal to *Vdd - IDAC \* R2P.* The new amount of electric charge stored in the first capacitor CP is substantially equal to *-IDAC \* R2P \* CP* and the new amount of electric charge stored in the parasitic capacitance CPAR is substantially equal to (*Vdd-*

*IDAC * R2P) * CPAR.*

As described above in relation to Figure 4, without the first charge supply circuit CSC1, the difference in the amount of electric charge in the parasitic capacitance CPAR before and after the falling-edge transition will create a transitional current flowing through the first adjustable resistor R2P which leads to a transitional voltage drop across the resistor R2P with a time constant determined by *R2P * CPAR*. By comparison, with the help of the first charge supply circuit CSC1, the first capacitor CP is operable to supply a suitable amount of electric charge to compensate the difference in the amount of electric charge in the parasitic capacitance CPAR before and after the falling-edge transition. As such, the current IPS flowing through the first adjustable resistor R2P as a result of the charging of the parasitic capacitance CPAR is significantly reduced or substantially cancelled. The perfect compensation of the charge difference in the parasitic capacitance CPAR before and after the falling-edge transition occurs when the sum of the charge difference in the first capacitor CP and the charge difference in the parasitic capacitance CPAR is equal to zero, which can be expressed by:

$$(Vdd + IDAC * R2P) * CP + \big((IDAC * R2N) - (Vdd - IDAC * R2P)\big) * CPAR = 0. \qquad (1)$$

Therefore, the capacitance of the first capacitor CP can be expressed by:

$$CP = \frac{Vdd - IDAC * (R2N + R2P)}{Vdd + IDAC * R2P} * CPAR. \qquad (2)$$

Therefore, by using a capacitor with a capacitance determined by equation (2) as the first capacitor CP, it is possible to prevent the transitional voltage VR2P from being created at the first supply terminal ST1 and thus the input data dependent behavior of the output current IDAC.

Rising edge transition (i.e. switching from logic LOW to logic HIGH)

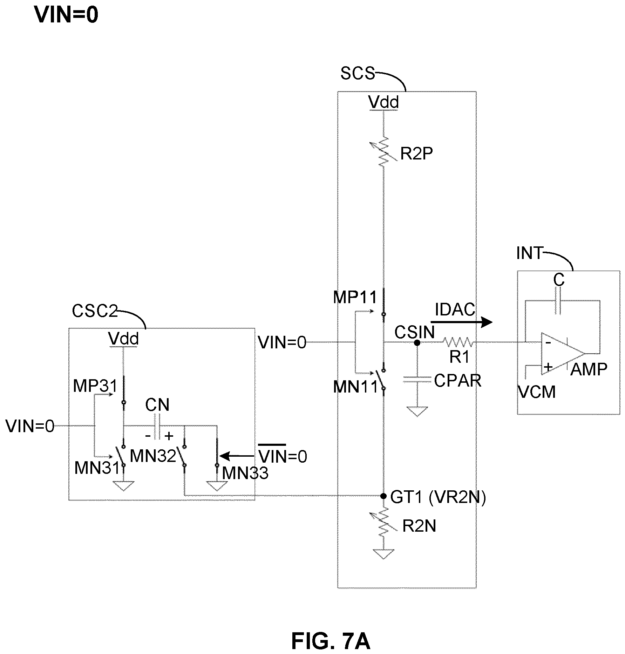

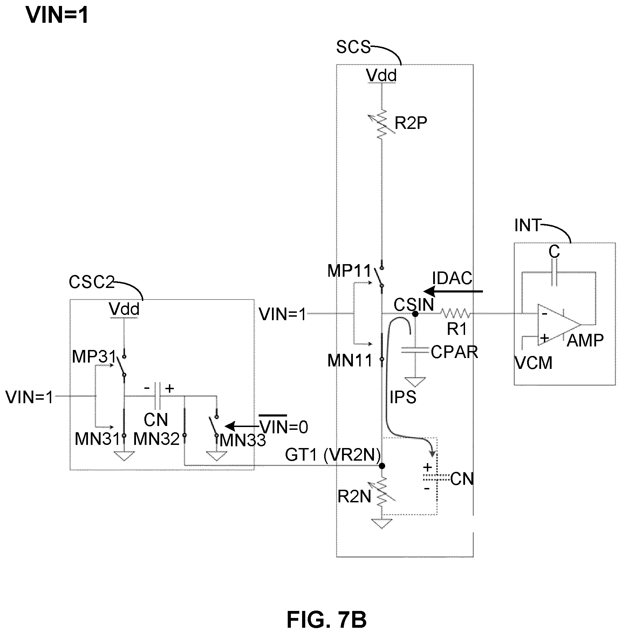

Figures 7A and 7B schematically illustrate a rising-edge operation of the switching voltage-controlled current source when the input logic signal is switched from a logic LOW (e.g., VIN = 0V) to a logic HIGH (e.g., VIN = 1V). At a rising edge transition, the second charge supply circuit CSC2 may be active.

With reference to Figure 7A, when the first input logic signal VIN is a logic LOW (e.g., VIN = 0V), the second capacitor CN is coupled at one end to the power supply Vdd (via the third P-type MOSFET transistor MP31) and at the other end to ground. The amount of electric charge stored by the second capacitor CN between its PLUS (+) and MINUS (-) terminals is substantially equal to *-Vdd * CN*. The voltage at the current source internal node CSIN (i.e. the voltage across the parasitic capacitance CPAR) is equal to *Vdd - IDAC * R2P* and the electric charge stored in the parasitic capacitance CPAR is substantially equal to (*Vdd - IDAC * R2P) * CPAR.*

With reference to Figure 7B, when the first input logic signal VIN is switched from a logic LOW (e.g., VIN = 0V) to a logic HIGH (e.g., VIN = 1V), the second capacitor CN is coupled between the ground (via the third N-type MOSFET transistor MN31) and the first ground terminal GT1 and the parasitic capacitance CPAR is coupled to the first ground terminal GT1 of the first logic circuit LGC1 (assuming the resistance of the first N-type MOSFET MN11 transistor is negligible). The voltage VR2N at the first ground terminal GT1 will settle to *IDAC * R2N*. The voltage across the second capacitor CN is substantially equal to *IDAC * R2N* and the voltage across the parasitic capacitance CPAR is substantially equal to *-IDAC * R2N*. The new amount of electric charge stored in the second capacitor CN is substantially equal to *-IDAC * R2N * CN* and the new amount of electric charge stored in the parasitic capacitance CPAR is substantially equal to *-IDAC * R2N * CPAR.*

As described above in relation to Figure 4, without the second charge supply circuit CSC2, the difference in the amount of electric charge in the parasitic capacitance CPAR before and after the rising-edge transition will create a transitional current flowing through the second adjustable resistor R2N which leads to a transitional voltage drop across the resistor R2N with a time constant determined by *R2N * CPAR*. By comparison, with the help of the first charge supply circuit CSC2, the second capacitor CN is operable to supply a suitable amount of electric charge to compensate the difference in the amount of electric charge in the parasitic capacitance CPAR before and after the rising-edge transition. As such, the current IPS flowing through the second adjustable resistor R2N as a result of the charging of the parasitic capacitance CPAR is significantly reduced or substantially cancelled. The perfect compensation of the charge difference in the parasitic capacitance CPAR before and after the rising-edge transition occurs when the sum of the charge difference in the second capacitor CN and the charge difference in the parasitic capacitance CPAR is equal to zero, which can be expressed by:

$$(-Vdd - IDAC * R2N) * CN + \big((Vdd - IDAC * R2P) - (IDAC * R2N)\big) * CPAR = 0. \qquad (3)$$

Therefore, the capacitance of the second capacitor CN can be expressed by:

$$CN = \frac{Vdd - IDAC*(R2N+R2P)}{Vdd + IDAC*R2N} * CPAR. \tag{4}$$

Therefore, by using a capacitor with a capacitance determined by equation (4) as the second capacitor CN, it is possible to prevent the transitional voltage VR2N from being created at the first ground terminal GT1 and thus the input data dependent behavior of the output current IDAC.

A second aspect of the present disclosure provides a method of compensating a parasitic capacitance in a switching voltage-controlled current source. The switching voltage-controlled current source may comprise: a current source input terminal for receiving a first input logic signal and a current source output terminal for outputting current; a first logic circuit comprising a first logic input terminal connected to the current source input terminal, a first logic output terminal for outputting a current control signal, a first supply terminal for connecting to a power supply and a first ground terminal for connecting to the ground; a first resistor coupled between the first logic output terminal and the current source output terminal; a second resistor coupled between the power supply and first supply terminal and a third resistor coupled between the ground and the first ground terminal; wherein the first logic circuit is operable to selectively couple the second resistor or the third resistor to the first resistor. The method may comprise: in response to switching of the first input logic signal from a first logic state (e.g., a logic HIGH) to a second logic state (e.g., a logic LOW, generating a first amount of electric charge by a first charge supply circuit to compensate a first charge difference in a parasitic capacitance formed at a current source internal node connected to the first logic output terminal and one end of the first resistor; and in response to switching of the first input logic signal from the second logic state to the first logic state, generating a second amount of electric charge by a second charge supply circuit to compensate a second charge difference in the parasitic capacitance formed at the current source internal node.

In an embodiment, the first charge supply circuit may comprise: a first charge supply input terminal connected to the current source input terminal; a first charge supply output terminal connected to the first supply terminal of the first logic circuit; a first internal voltage node; a second logic circuit comprising a second logic input terminal connected to the first charge supply input terminal and a second logic output terminal, said second logic circuit being configured to have a same functional behavior as the first logic circuit; a first capacitor coupled between the second logic output terminal and the first internal voltage node; a first switch coupled between the first charge supply output terminal and the first internal voltage node, the state of the first switch being controlled by the first input logic signal; and a second switch coupled between the first internal voltage node and the power supply, and the state of the second switch being controlled by a second input logic signal having an opposite polarity to the first input logic signal.

In an embodiment, the second charge supply circuit may comprise: a second charge supply input terminal connected to the current source input terminal; a second charge supply output terminal connected to the first ground terminal of the first logic circuit; a second internal voltage node; a third logic circuit comprising a third logic input terminal connected to the second charge supply input terminal, and a third logic output terminal, said third logic circuit being configured to have a same functional behavior as the first logic circuit; a second capacitor coupled between the second logic output terminal and the second internal voltage node; a third switch coupled between the second charge supply output terminal and the second internal voltage node, the state of the third switch being controlled by the first input logic signal; and a fourth switch coupled between the second internal voltage node and the ground, and the state of the fourth switch being controlled by the second input logic signal.

The description provided herein may be directed to specific implementations. It should be understood that the discussion provided herein is provided for the purpose of enabling a person with ordinary skill in the art to make and use any subject matter defined herein by the subject matter of the claims.

It should be intended that the subject matter of the claims is not limited to the implementations and illustrations provided herein, but include modified forms of those implementations including portions of implementations and combinations of elements of different implementations in accordance with the claims. It should be appreciated that in the development of any such implementation, as in any engineering or design project, numerous implementation-specific decisions should be made to achieve a developers' specific goals, such as compliance with system-related and business-related constraints, which may vary from one implementation to another. Moreover, it should be appreciated that such a development effort may be complex and time consuming, but would nevertheless be a routine undertaking of design, fabrication, and manufacture for those of ordinary skill having benefit of this invention.

Reference has been made in detail to various implementations, examples of which are illustrated in the accompanying drawings and figures. In the detailed description, numerous specific details are set forth to provide a thorough understanding of the invention provided herein. However, the invention provided herein may be practiced without these specific details. In some other instances, well-known methods, procedures, components, circuits, and networks have not been described in detail so as not to unnecessarily obscure details of the embodiments.

It should also be understood that, although the terms first, second, etc. may be used herein to describe various elements, these elements should not be limited by these terms. These terms are only used to distinguish one element from another. For example, a first element could be termed a second element, and, similarly, a second element could be termed a first element. The first element and the second element are both elements, respectively, but they are not to be considered the same element.

The terminology used in the description of the invention provided herein is for the purpose of describing particular implementations and is not intended to limit the invention provided herein. As used in the description of the invention provided herein and appended claims, the singular forms "a," "an," and "the" are intended to include the plural forms as well, unless the context clearly indicates otherwise. The term "and/or" as used herein refers to and encompasses any and all possible combinations of one or more of the associated listed items. The terms "includes," "including," "comprises," and/or "comprising," when used in this specification, specify a presence of stated features, integers, steps, operations, elements, and/or components, but do not preclude the presence or addition of one or more other features, integers, steps, operations, elements, components and/or groups thereof.

While the foregoing is directed to implementations of various techniques described herein, other and further implementations may be devised in accordance with the invention herein, which may be determined by the claims that follow. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1.  A switching voltage-controlled current source, comprising:

    a current source input terminal for receiving a first input logic signal and a current source output terminal for outputting current;
    a first logic circuit comprising a first logic input terminal connected to the current source input terminal, a first logic output terminal for outputting a current control signal, a first supply terminal for connecting to a power supply and a first ground terminal for connecting to the ground;
    a first resistor coupled between the first logic output terminal and the current source output terminal;
    a second resistor coupled between the power supply and first supply terminal and a third resistor coupled between the ground and the first ground terminal;
    wherein the first logic circuit is operable to selectively couple the second resistor or the third resistor to the first resistor;
    a first charge supply circuit configured to supply a first amount of electric charge to compensate a first charge difference in a parasitic capacitance formed at a current source internal node connected to the first logic output terminal and one end of the first resistor in response to switching of the first input logic signal from a first logic state to a second logic state; and
    a second charge supply circuit configured to supply a second amount of electric charge to compensate a second charge difference in the parasitic capacitance formed at the current source internal node in response to switching of the first input logic signal from the second logic state to the first logic state.

2.  A switching voltage-controlled current source as claimed in claim 1, wherein the first charge supply circuit comprising:

    a first charge supply input terminal connected to the current source input terminal;
    a first charge supply output terminal connected to the first supply terminal of the first logic circuit;
    a first internal voltage node;
    a second logic circuit comprising a second logic input terminal connected to the first charge supply input terminal and a second logic output terminal, said second logic circuit being configured to have a same functional behavior as the first logic circuit;
    a first capacitor coupled between the second logic output terminal and the first internal voltage node;
    a first switch coupled between the first charge supply output terminal and the first internal voltage node, the state of the first switch being controlled by the first input logic signal; and
    a second switch coupled between the first internal voltage node and the power supply, and the state of the second switch being controlled by a second input logic signal having an opposite polarity to the first input logic signal.

3.  A switching voltage-controlled current source as claimed in claim 1 or 2, wherein the second charge supply circuit comprising:

a second charge supply input terminal connected to the current source input terminal;

a second charge supply output terminal connected to the first ground terminal of the first logic circuit;

a second internal voltage node;

a third logic circuit comprising a third logic input terminal connected to the second charge supply input terminal and a third logic output terminal, said third logic circuit being configured to have a same functional behavior as the first logic circuit;

a second capacitor coupled between the second logic output terminal and the second internal voltage node;

a third switch coupled between the second charge supply output terminal and the second internal voltage node, the state of the third switch being controlled by the first input logic signal; and

a fourth switch coupled between the second internal voltage node and the ground, and the state of the fourth switch being controlled by the second input logic signal.

4. A switching voltage-controlled current source as claimed in any preceding claim, wherein the electric resistance of the second resistor and/or the third resistor is adjustable.

5. A switching voltage-controlled current source as claimed in claim 4, wherein the second resistor comprises a first fixed resistor and one or more second fixed resistors, wherein each of the one or more second fixed resistors is in series with a fifth switch, and each pair of a second fixed resistor and a fifth switch is parallelly connected to the first fixed resistor; and/or wherein the third resistor comprises a third fixed resistor and one or more fourth fixed resistors, wherein each of the one or more fourth fixed resistors is in series with a sixth switch, and each pair of a fourth fixed resistor and a sixth switch is parallelly connected to the third fixed resistor.

6. A switching voltage-controlled current source as claimed in any preceding claim, wherein the first switch and the second switch of the first charge supply circuit are both P-type MOSFET transistors, and/or the third switch and the fourth switch of the second charge supply circuit are both N-type MOSFET transistors.

7. A switching voltage-controlled current source as claimed in any preceding claim, wherein the first capacitor of the first charge supply circuit is coupled to the power supply and decoupled from the first charge supply output terminal when the first logic circuit decouples the first resistor from the second resistor; and/or wherein the first capacitor of the first charge supply circuit is decoupled from the power supply and coupled to the first charge supply output terminal when the first logic circuit couples the first resistor to the second resistor.

8. A switching voltage-controlled current source as claimed in any preceding claim, wherein the second capacitor of the second charge supply circuit is coupled to the ground and decoupled from the second charge supply output terminal when the first logic circuit decouples the first resistor from the third resistor; and/or wherein the second capacitor of the second charge supply circuit is decoupled from the ground and coupled to the second charge supply output terminal when the first logic circuit couples the first resistor to the third resistor.

9. A switching voltage-controlled current source as claimed in any preceding claim, being operable to output a first current when the first input logic signal is of a first state and output a second current when the first input logic signal is of a second state, said second current having a similar or same absolute value as the first current but with an opposite polarity.

10. A switching voltage-controlled current source as claimed in any preceding claim, wherein the second logic circuit of the first charge supply circuit and the third logic circuit of the second charge supply circuit are same as the first logic circuit, or the second logic circuit of the first charge supply circuit and the third logic circuit of the second charge supply circuit are different than the first logic circuit but with a same functional behavior as the first logic circuit.

11. A switching voltage-controlled current source as claimed in any preceding claim, wherein the first logic circuit is an inverter.

12. A switching voltage-controlled current source as claimed in any preceding claim, wherein the first logic state is a logic HIGH and the second logic state is a logic LOW.

13. A digital-to-analog converter comprising at least one switching voltage-controlled current source as claimed in any preceding claim.

14. A delta-sigma modulator comprising:

at least one digital-to-analog converter as claimed in claim 13, and
at least one integrator for receiving the current from the at least one switching voltage-controlled current source of the at least one digital-to-analog converter.

15. A method of compensating a parasitic capacitance in a switching voltage-controlled current source,

the switching voltage-controlled current source comprising:

a current source input terminal for receiving a first input logic signal and a current source output terminal for outputting current;
a first logic circuit comprising a first logic input terminal connected to the current source input terminal, a first logic output terminal for outputting a current control signal, a first supply terminal for connecting to a power supply and a first ground terminal for connecting to the ground;
a first resistor coupled between the first logic output terminal and the current source output terminal;
a second resistor coupled between the power supply and first supply terminal and a third resistor coupled between the ground and the first ground terminal;
wherein the first logic circuit is operable to selectively couple the second resistor or the third resistor to the first resistor;

the method comprising:

in response to switching of the first input logic signal from a first logic state to a second logic state, generating a first amount of electric charge by a first charge supply circuit to compensate a first charge difference in a parasitic capacitance formed at a current source internal node connected to the first logic output terminal and one end of the first resistor; and
in response to switching of the first input logic signal from the second logic state to the first logic state, generating a second amount of electric charge by a second charge supply circuit to compensate a second charge difference in the parasitic capacitance formed at the current source internal node.

**FIG. 1**

**FIG. 2**

**FIG. 3**

**FIG. 4**

FIG. 5

**VIN=1**

**FIG. 6A**

**VIN=0**

**FIG. 6B**

VIN=0

FIG. 7A

**VIN=1**

**FIG. 7B**

Europäisches
Patentamt
European
Patent Office
Office européen
des brevets

# EUROPEAN SEARCH REPORT

**Application Number**

EP 24 30 6772

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/184270 A1 (HUAWEI TECH CO LTD [CN]; KOLI KIMMO [SE]) 9 September 2022 (2022-09-09) | 1,4,5,9, 11-15 | INV. H03M1/08 H03M1/74 |
| A | * page 11, lines 16-23 * * page 13, lines 26-29; figure 3 * | 2,3,6-8, 10 | H03K17/16 H03M3/02 H03M3/04 |
| A | US 2017/077936 A1 (KAO TSUNG-KAI [TW]) 16 March 2017 (2017-03-16) * figures 4a,4b * | 1-15 | |
| A | US 9 806 730 B1 (DUSAD SHAGUN [IN] ET AL) 31 October 2017 (2017-10-31) * figure 1b * | 1-15 | |

**TECHNICAL FIELDS SEARCHED (IPC)**

H03K
H03M

The present search report has been drawn up for all claims

| Place of search | Date of completion of the search | Examiner |
|---|---|---|
| The Hague | 25 March 2025 | Galardi, Leonardo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 6772

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2025

| Patent document cited in search report | | Publication date | Patent family member(s) | | Publication date |
|---|---|---|---|---|---|
| WO 2022184270 | A1 | 09-09-2022 | CN | 116964942 A | 27-10-2023 |
| | | | WO | 2022184270 A1 | 09-09-2022 |
| US 2017077936 | A1 | 16-03-2017 | CN | 107070456 A | 18-08-2017 |
| | | | EP | 3145086 A1 | 22-03-2017 |
| | | | US | 2017077936 A1 | 16-03-2017 |
| US 9806730 | B1 | 31-10-2017 | CN | 108270445 A | 10-07-2018 |
| | | | US | 9806730 B1 | 31-10-2017 |

EPO FORM P0459